(19) Europäisches Patentamt / European Patent Office / Office européen des brevets

(11) **EP 2 568 600 B1**

(12) **FASCICULE DE BREVET EUROPEEN**

(45) Date de publication et mention
de la délivrance du brevet:
**03.10.2018   Bulletin 2018/40**

(51) Int Cl.:
*H03F 3/08* (2006.01)    *H03F 3/45* (2006.01)
*H03K 17/78* (2006.01)    *H03F 3/68* (2006.01)

(21) Numéro de dépôt: **12180090.8**

(22) Date de dépôt: **10.08.2012**

(54) **Dispositif de détection avec un montage transimpédance**

Erfassungsvorrichtung mit einer Transimpedanzschaltung

Detection device provided with a transimpedance circuit

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:   **07.09.2011   FR 1157905**

(43) Date de publication de la demande:
**13.03.2013   Bulletin 2013/11**

(73) Titulaire: **Schneider Electric Industries SAS
92500 Rueil-Malmaison (FR)**

(72) Inventeurs:
• **Chiesi, Laurent
38140 Réaumont (FR)**
• **Raisigel, Hynek
38360 Sassenage (FR)**

(74) Mandataire: **Dufresne, Thierry et al
Schneider Electric Industries SAS
Service Propriété Industrielle
35 rue Joseph Monier - CS 30323
92506 Rueil-Malmaison Cedex (FR)**

(56) Documents cités:
WO-A1-2006/031793    WO-A1-2010/100741
WO-A2-2006/049985    US-B1- 7 170 338

• TAKAGI S ET AL: "Multi-path analog circuits robust to digital substrate noise", IEICE TRANSACTIONS ON FUNDAMENTALS OF ELECTRONICS,COMMUNICATIONS AND COMPUTER SCIENCES, ENGINEERING SCIENCES SOCIETY, TOKYO, JP, vol. E91A, no. 2, 1 février 2008 (2008-02-01), pages 535-541, XP001511216, ISSN: 0916-8508, DOI: 10.1093/IETFEC/E91-A.2.535
• Anonymous: "Bridged and paralleled amplifiers - Wikipedia, the free encyclopedia", , 8 January 2010 (2010-01-08), XP055169832, Retrieved from the Internet: URL:https://web.archive.org/web/2010010821 5441/http://en.wikipedia.org/wiki/Bridge-T ied_Load [retrieved on 2015-02-16]

EP 2 568 600 B1

## Description

### Domaine technique de l'invention

La présente invention se rapporte à un dispositif de détection doté d'un montage amplificateur transimpédance.

### Etat de la technique

Il existe des dispositifs de détection destinés à détecter différents types de gaz. Ces dispositifs sont basés sur une association d'un émetteur optique composé d'une diode électroluminescente permettant d'émettre un signal lumineux, et d'un récepteur composé d'une photodiode destinée à capter le signal lumineux pour le transformer en courant électrique exploitable par des moyens de traitement. Les émetteurs optiques existent pour différentes longueurs d'onde, ce qui permet de détecter différents types de gaz en fonction de la longueur d'onde d'absorption du gaz. De plus, ces dispositifs comportent en sortie un montage amplificateur transimpédance permettant d'amplifier le courant en sortie de la photodiode afin d'obtenir une tension de sortie. Ce montage amplificateur transimpédance comporte en général un seul amplificateur opérationnel doté d'une entrée négative, d'une entrée positive et d'une sortie. La photodiode est connectée entre l'entrée positive et l'entrée négative de l'amplificateur opérationnel et une résistance de gain est connectée entre l'entrée négative et la sortie de l'amplificateur opérationnel.

Les photodiodes qui travaillent dans la zone d'absorption du dioxyde de carbone ($CO_2$) présentent malheureusement une résistance parallèle (appelée résistance shunt) très faible (quelques dizaines d'ohms). Comme la résistance shunt de la photodiode est très faible devant la résistance de gain, le bruit à la sortie du montage transimpédance est fortement amplifié. Cela s'explique simplement par la relation suivante :

$$e_{out} \approx \frac{R_{gain}}{R_{shunt}} \cdot \sqrt{e_{aop}^2 + 4 \cdot k \cdot T \cdot R_{shunt}}$$

Dans laquelle :

- $e_{out}$ correspond au bruit à la sortie du montage transimpédance,
- $R_{gain}$ représente la résistance de gain,
- $R_{shunt}$ correspond à la résistance shunt de la photodiode,
- $e_{aop}$ correspond au bruit en tension d'entrée généré par un amplificateur opérationnel,
- $k$ est la constante de Boltzmann,
- $T$ correspond à la température.

Dans les montages actuels, pour réduire le bruit en sortie du montage amplificateur transimpédance, on utilise un amplificateur opérationnel ayant un bruit en tension d'entrée le plus faible possible. Cependant, pour certaines applications, comme celle d'un dispositif de détection de dioxyde de carbone à faible consommation d'énergie, les caractéristiques des amplificateurs opérationnels existants ne sont pas satisfaisantes.

Il est connu des documents WO2006/031793 et WO2006/049985 des systèmes amplificateur de signaux.

Le but de l'invention est de proposer un dispositif de détection doté d'un montage amplificateur transimpédance dans lequel le bruit à la sortie du montage amplificateur transimpédance est réduit.

### Exposé de l'invention

Ce but est atteint par un dispositif de détection selon la revendication 1.

Selon une autre particularité, la première résistance et la deuxième résistance présentent une valeur inférieure à celle de la résistance de gain.

Selon une autre particularité, la première résistance et la deuxième résistance présentent une valeur identique.

Selon une autre particularité, la valeur des résistances est choisie supérieure à la plus grande des impédances de sortie des amplificateurs opérationnels.

### Brève description des figures

D'autres caractéristiques et avantages vont apparaître dans la description détaillée qui suit faite en regard des dessins annexés dans lesquels :

- la figure 1 représente le schéma du montage amplificateur transimpédance connecté à une photodiode dans un dispositif de détection,
- la figure 2 représente une courbe illustrant l'effet du nombre d'amplificateurs opérationnels en série sur le rapport signal sur bruit, avec en abscisses le nombre d'amplificateurs opérationnels employés et en ordonnées le gain sur le rapport signal sur bruit.

**Description détaillée d'au moins un mode de réalisation**

L'invention concerne un dispositif de détection, notamment pour détecter la présence de gaz, tel que le dioxyde de carbone. Le dispositif de détection de l'invention présente la particularité de consommer très peu d'énergie.

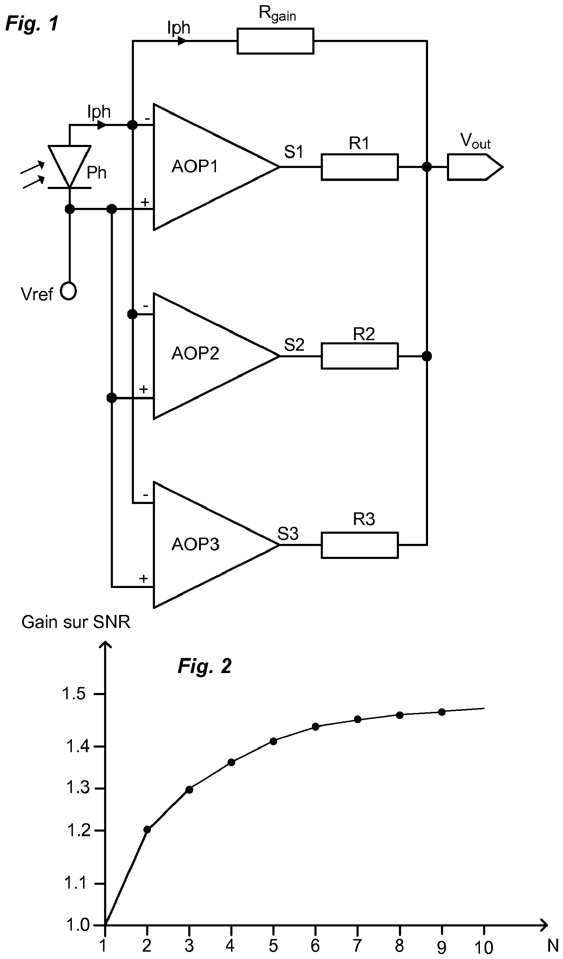

Ce dispositif de détection comporte un récepteur composé d'une photodiode Ph destinée à capter un signal lumineux et à le transformer en courant électrique Iph. Sur la figure 1, la photodiode est orientée dans un sens mais il faut comprendre qu'elle peut être orientée dans le sens inverse.

Selon l'invention, le dispositif comporte également un montage amplificateur transimpédance connecté aux bornes de la photodiode Ph et permettant d'amplifier le courant émis par la photodiode Ph.

Le montage amplificateur transimpédance de l'invention présente la particularité de comporter au moins deux amplificateurs opérationnels en parallèle. Sur la figure 1, trois amplificateurs opérationnels AOP1, AOP2, AOP3 sont connectés à la photodiode Ph mais on peut imaginer en connecter un nombre plus important. Bien entendu, l'invention doit être comprise comme si le montage amplificateur transimpédance pouvait comporter N amplificateurs opérationnels connectés en parallèle, avec N≥2.

En référence à la figure 1, chaque amplificateur opérationnel AOP1, AOP2, AOP3 comporte une entrée positive (désignée + sur la figure 1), une entrée négative (désignée - sur la figure 1) et une sortie S1, S2, S3. Les entrées négatives des amplificateurs opérationnels sont connectées entre elles et à l'une des deux bornes de la photodiode pour recevoir le courant Iph généré par la photodiode Ph et les entrées positives des amplificateurs opérationnels sont connectées entre elles, à l'autre des deux bornes de la photodiode Ph ainsi qu'à une source de tension fournissant une tension de référence Vref. Si les amplificateurs opérationnels qui sont employés sont différents, le montage amplificateur transimpédance comporte de préférence plusieurs résistances R1, R2, R3 connectées chacune en série sur la sortie S1, S2, S3 d'un amplificateur opérationnel distinct. Ces résistances R1, R2, R3 permettent d'équilibrer les courants en sortie des amplificateurs. Ces résistances R1, R2, R3 présentent par exemple toutes une valeur identique et cette valeur est avantageusement choisie supérieure à la plus grande des impédances de sortie des amplificateurs opérationnels.

Enfin, le montage transimpédance comporte également une résistance de gain $R_{gain}$ en parallèle des amplificateurs et de leur résistance en série. Cette résistance de gain $R_{gain}$ est connectée sur les entrées négatives des amplificateurs opérationnels. Selon l'invention les résistances R1, R2, R3 sont employées. La résistance de gain $R_{gain}$ peut présenter une valeur supérieure à la valeur de ces résistances R1, R2, R3.

Cet agencement en parallèle de N amplificateurs opérationnels permet en effet de réduire par $\sqrt{N}$ la contribution du bruit en tension d'entrée de l'amplificateur opérationnel dans l'expression du bruit en sortie du montage amplificateur transimpédance.

Avec le montage de l'invention, le bruit à la sortie du montage amplificateur transimpédance s'exprime alors de la manière suivante :

$$e_{out} \approx \frac{R_{gain}}{R_{shunt}} \cdot \sqrt{\left(\frac{e_{aop}}{\sqrt{N}}\right)^2 + 4 \cdot k \cdot T \cdot R_{shunt}}$$

Par ailleurs, l'emploi d'une seule branche de compensation qui comporte la résistance de gain $R_{gain}$ pour tous les amplificateurs opérationnels et non d'une branche de compensation par amplificateur opérationnel permet d'éviter que le courant Iph émis par la photodiode Ph ne se sépare dans les différentes branches et diminue donc d'autant le signal amplifié.

Le signal $V_{out}$ obtenu en sortie du montage amplificateur transimpédance s'exprime ainsi de la manière suivante :

$$V_{out} = R_{gain} \cdot I_{ph.}$$

Le rapport signal sur bruit (SNR) à la sortie du montage amplificateur transimpédance est alors le suivant :

$$SNR = \frac{R_{shunt} \cdot I_{ph.}}{\sqrt{\left(\dfrac{e_{aop}}{\sqrt{N}}\right)^2 + 4 \cdot k \cdot T \cdot R_{shunt}}}$$

A partir de cette expression, on peut voir qu'il est intéressant de multiplier le nombre d'amplificateurs opérationnels en parallèle pour augmenter le rapport signal sur bruit. La courbe représentée sur la figure 2 permet d'illustrer ce phénomène. Cette courbe montre que le gain est réellement intéressant avec trois ou quatre amplificateurs opérationnels. Au-delà, le rapport signal sur bruit n'augmente plus de manière significative et ne permet pas de justifier une augmentation correspondante du coût de la solution, de son encombrement et de sa consommation électrique. Le comportement asymptotique de cette courbe traduit le fait que le bruit thermique de la résistance shunt devient prédominant à partir d'une certaine valeur de N.

## Revendications

1. Dispositif de détection comportant une photodiode (Ph) destinée à capter un signal lumineux pour le transformer en un courant (Iph) et comportant une première borne et une deuxième borne, un montage amplificateur transimpédance connecté entre la première borne et la deuxième borne de la photodiode (Ph) et destiné à amplifier le courant (Iph) issu de la photodiode (Ph), **caractérisé en ce que** le montage amplificateur transimpédance comporte :

   - un premier amplificateur opérationnel (AOP1) comportant une entrée positive, une entrée négative et une sortie (S1),
   - un deuxième amplificateur opérationnel (AOP2) comportant une entrée positive connectée à l'entrée positive du premier amplificateur opérationnel (AOP1), une entrée négative connectée à l'entrée négative du premier amplificateur opérationnel et une sortie (S2),
   - une première résistance (R1) connectée en série avec la sortie (S1) du premier amplificateur opérationnel (AOP1) et une deuxième résistance (R2) connectée en série avec la sortie (S2) du deuxième amplificateur opérationnel (AOP2),

   la première résistance étant connectée à la deuxième résistance,

   - une résistance de gain (Rgain) commune connectée aux entrées négatives du premier amplificateur et du deuxième amplificateur et en parallèle des deux amplificateurs opérationnels (AOP1, AOP2) et de leur résistance connectée en série.

2. Dispositif selon la revendication 1, **caractérisé en ce que** la première résistance (R1) et la deuxième résistance (R2) présentent une valeur inférieure à celle de la résistance de gain (Rgain).

3. Dispositif selon la revendication 2, **caractérisé en ce que** la première résistance (R1) et la deuxième résistance (R2) présentent une valeur identique.

4. Dispositif selon la revendication 3, **caractérisé en ce que** la valeur de la première résistance ou de la deuxième résistance est choisie supérieure à la plus grande des impédances de sortie des amplificateurs opérationnels (AOP1, AOP2).

## Patentansprüche

1. Erfassungsvorrichtung, umfassend eine Fotodiode (Ph), die dazu bestimmt ist, ein Lichtsignal zu erfassen, um es in Strom (Iph) umzuwandeln, und umfassend eine erste Klemme und eine zweite Klemme, eine Transimpedanz-Verstärkerschaltung, die zwischen der ersten Klemme und der zweiten Klemme der Fotodiode (Ph) angeschlossen und dazu bestimmt ist, den von der Fotodiode (Ph) stammenden Strom (Iph) zu verstärken, **dadurch gekennzeichnet, dass** die Transimpedanz-Verstärkerschaltung umfasst:

   - einen ersten Operationsverstärker (AOP1), umfassend einen positiven Eingang, einen negativen Eingang und einen Ausgang (S1),
- einen zweiten Operationsverstärker (AOP2), umfassend einen positiven Eingang, der an den positiven Eingang des ersten Operationsverstärkers (AOP1) angeschlossen ist, einen negativen Eingang, der an den negativen Eingang des ersten Operationsverstärkers angeschlossen ist, und einen Ausgang (S2),
- einen ersten Widerstand (R1), der in Serie mit dem Ausgang (S1) des ersten Operationsverstärkers (AOP1) geschaltet ist, und einen zweiten Widerstand (R2), der in Serie mit dem Ausgang (S2) des zweiten Operationsverstärkers (AOP2) geschaltet ist, wobei der erste Widerstand an den zweiten Widerstand angeschlossen ist,
- einen gemeinsamen Verstärkungswiderstand (Rgain), der an die negativen Eingänge des ersten Verstärkers und des zweiten Verstärkers und parallel zu den zwei Operationsverstärkern (AOP1, AOP2) und ihren in Serie geschalteten Widerstand angeschlossen ist.

2. Vorrichtung nach Anspruch 1, **dadurch gekennzeichnet, dass** der erste Widerstand (R1) und der zweite Widerstand (R2) einen kleineren Wert als jener des Verstärkungswiderstands (Rgain) aufweisen.

3. Vorrichtung nach Anspruch 2, **dadurch gekennzeichnet, dass** der erste Widerstand (R1) und der zweite Widerstand (R2) einen identischen Wert aufweisen.

4. Vorrichtung nach Anspruch 3, **dadurch gekennzeichnet, dass** der Wert des ersten Widerstands oder des zweiten Widerstands größer als die größte der Ausgangsimpedanzen der Operationsverstärker (AOP1, AOP2) gewählt ist.

## Claims

1. Detection device including a photodiode (Ph) designed to capture a luminous signal to transform it into a current (Iph) and having a first terminal and a second terminal, a transimpedance amplifier circuit connected between the first terminal and the second terminal of the photodiode (Ph) and designed to amplify the current (Iph) coming from the photodiode (Ph), **characterized in that** the transimpedance amplifier circuit includes:

- a first operational amplifier (AOP1) having a positive input, a negative input and an output (S1),
- a second operational amplifier (AOP2) having a positive input connected to the positive input of the first operational amplifier (AOP1), a negative input connected to the negative input of the first operational amplifier, and an output (S2),
- a first resistor (R1) connected in series with the output (S1) of the first operational amplifier (AOP1), and a second resistor (R2) connected in series with the output (S2) of the second operational amplifier (AOP2), the first resistor being connected to the second resistor,
- a common gain resistor ($R_{gain}$) connected to the negative inputs of the first amplifier and the second amplifier, and in parallel with the two operational amplifiers (AOP1, AOP2) and their resistor connected in series.

2. Device according to Claim 1, **characterized in that** the first resistor (R1) and the second resistor (R2) have a value lower than that of the gain resistor ($R_{gain}$).

3. Device according to Claim 2, **characterized in that** the first resistor (R1) and the second resistor (R2) have the same value.

4. Device according to Claim 3, **characterized in that** the value of the first resistor or the second resistor is chosen to be greater than the highest of the output impedances of the operational amplifiers (AOP1, AOP2).

**Fig. 1**

**Fig. 2**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2006031793 A
- WO 2006049985 A